(19) **Europäisches Patentamt**
**European Patent Office**
**Office européen des brevets**

(11) **EP 2 544 245 A1**

(12) **EUROPEAN PATENT APPLICATION**
published in accordance with Art. 153(4) EPC

(43) Date of publication:
**09.01.2013 Bulletin 2013/02**

(51) Int Cl.:
***H01L 31/048*** (2006.01)

(21) Application number: **11750730.1**

(22) Date of filing: **24.02.2011**

(86) International application number:
**PCT/JP2011/054836**

(87) International publication number:
**WO 2011/108621 (09.09.2011 Gazette 2011/36)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.03.2010 JP 2010046122**

(71) Applicant: **Nisshinbo Mechatronics Inc.
Tokyo 103-8650 (JP)**

(72) Inventors:
• **NAKAHAMA Hidenari
Aichi 4448560 (JP)**
• **IIDA Hirotaka
Aichi 4448560 (JP)**
• **NAKANO Hiroshi
Aichi 4448560 (JP)**

(74) Representative: **Leifert & Steffan
Patentanwälte
Postfach 10 40 09
40031 Düsseldorf (DE)**

(54) **CROSSLINK DENSITY MEASUREMENT SHEET**

(57)     Disclosed is a crosslinking density measurement sheet from which information for determining an actual manufacturing condition of a laminator for manufacturing a solar cell module is obtainable. The manufacturing condition of a laminator for manufacturing a solar cell module can be determined within a short period of time by constituting the crosslinking density measurement sheet as a composite sheet provided with a support and a rubber sheet member integrated with the support and estimating a crosslinking density of a encapsulant within a solar cell module from a change of the crosslinking density of the rubber sheet member before and after a laminating treatment with the laminator for manufacturing a solar cell module.

[FIG. 1]

## Description

TECHNICAL FIELD

The present invention relates to a crosslinking density measurement sheet from which at the time of determining a laminating processing condition using a laminating apparatus, a crosslinking density within a module can be estimated.

BACKGROUND ART

In a solar cell module, for the purposes of protecting a solar cell and keeping the shape of the module itself, the solar cell is fixed using a encapsulant. For this encapsulant, transparent resins such as an ethylene-vinyl acetate copolymer resin (EVA resin), etc. are utilized. In order to impart desired strength and durability to the encapsulant, it is frequently carried out to adjust physical properties of the encapsulant with a crosslinking agent inclusive of organic peroxides, and this crosslinking reaction is conducted in a laminating step of processing a solar cell module. When a crosslinking density of the encapsulant is too high, the encapsulant becomes brittle, causing breakage or cracking, whereas the crosslinking density is too low, the strength is insufficient, causing separation of the encapsulant. Since these faults become a factor of penetration of water into the solar cell module to cause breakage of the solar cell, it is necessary to control a variability of the crosslinking density of the encapsulant to an optimum range.

The crosslinking density of the encapsulant is influenced by a crosslinking temperature or a reaction time. In particular, while the crosslinking density is largely influenced by the temperature, there is a machine difference of every laminating apparatus or a temperature distribution in the inside of the laminating apparatus. In consequence, it is necessary to precisely adjust the temperature distribution within the laminating apparatus in an installation process of the laminating apparatus. In addition, in general, in view of the fact that there is a tendency that the crosslinking density is low in the periphery or the four corners and high in the center due to a warpage of a transparent substrate (chiefly a glass substrate), at every time of changing the composition or kind of the encapsulant and at every time of changing the size or constitution of a solar cell module to be manufactured, it is necessary to adjust the temperature distribution within the laminating apparatus, and it is necessary to frequently adjust the temperature distribution. Up to date, it has been conducted to adjust the temperature distribution within the laminating apparatus by measuring the crosslinking density using a constitution of a back sheet, a encapsulant, and a surface layer, which is actually utilized in the manufacture of a solar cell module, as it is.

SUMMARY OF THE INVENTION

PROBLEMS TO BE SOLVED BY THE INVENTION

But, a encapsulant which is generally used for the manufacture of a solar cell module, such as an EVA resin, etc., strongly adheres to glass. In order to measure the crosslinking density, it is necessary to take out the encapsulant by disassembling the solar cell module. However, the crosslinking density could not be measured by a solvent swelling method as described later because the disassembly of the solar cell module using glass is troublesome, the recovery of a sample is difficult, and the EVA resin is a crystalline resin.

As a result, there was involved such a problem that it takes a lot of time for measuring and evaluating the crosslinking density, and the production costs increase. In view of such circumstances, the present invention has been made, and its object is to provide a crosslinking density measurement sheet from which information for determining an actual manufacturing condition is obtainable.

MEANS FOR SOLVING THE PROBLEMS

The present invention is concerned with:

(1) A crosslinking density measurement sheet comprising a composite sheet provided with a support and a rubber sheet member integrated with the support, wherein
a crosslinking density of a encapsulant within a solar cell module can be calculated from a change of crosslinking density of the rubber sheet member before and after a laminating treatment by a solar cell module manufacturing laminator;

(2) The crosslinking density measurement sheet as set forth in (1), wherein the solar cell module manufacturing laminator is a laminating apparatus having an upper chamber and a lower chamber partitioned from each other by a diaphragm, in which a material to be processed is disposed on a hot plate provided in the lower chamber, and the material to be processed as heated by the hot plate is laminated by evacuating the lower chamber, introducing the air into the upper chamber, and compressing the material by the hot plate and the pressing member;

(3) The crosslinking density measurement sheet as set forth in (1) to (2), wherein at least one of a slit part, a concave part, and a through-hole part is formed in the rubber sheet member;

(4) The crosslinking density measurement sheet as set forth in (3), wherein the slit part is a linear groove having a width of from 0.1 mm to 5 mm, and the number of the groove is 1 to 10 per cm of the rubber sheet member;

(5) The crosslinking density measurement sheet as set forth in (3), wherein the concave part is a linear groove having a width of from 0.1 mm to 5 mm, and the number of the groove is 1 to 10 per cm of the rubber sheet member;

(6) The crosslinking density measurement sheet as set forth in (3), wherein the number of the concave part or the through-hole part is 1 to 10 per $cm^2$ of the rubber sheet member;

(7) The crosslinking density measurement sheet as set forth in (3), (5) and (6), wherein the concave part of the rubber sheet member is fabricated by embossing;

(8) The crosslinking density measurement sheet as set forth in (1) to (7), wherein the crosslinking density of the rubber sheet member is from $9.0 \times 10$ to $9.0 \times 10^{-7}$ moles/$cm^3$;

(9) The crosslinking density measurement sheet as set forth in (1) to (8), wherein a main component of the rubber sheet member is an ethylene/$\alpha$-olefin copolymer rubber (EPM) and/or an ethylene/$\alpha$-olefin/non-conjugated diene copolymer rubber (EPDM);

(10) The crosslinking density measurement sheet as set forth in (9), wherein a carbon number of the $\alpha$-olefin is from 2 to 8;

(11) A method for manufacturing a crosslinking density measurement sheet including a composite sheet provided with a support and a rubber sheet member integrated with the support, wherein a crosslinking density of a encapsulant within a solar cell module can be calculated from a change of crosslinking density of the rubber sheet member before and after a laminating treatment by a solar cell module manufacturing laminator, the method comprising

a step of measuring a time $t_{10}$ (encapsulant) until reaching 10 % of a maximum torque at the time of measuring a vulcanization curve by a vulcanization test on a encapsulant for a solar cell module,

a step of measuring a time $t_{90}$ (encapsulant) until reaching 90 % of a maximum torque at the time of measuring a vulcanization curve by a vulcanization test on a encapsulant for a solar cell module, and

a step of adjusting a crosslinking rate by adding an additive to a rubber member such that a time $t_{10}$ (measurement sheet) until reaching 10 % of a maximum torque at the time of measuring a vulcanization curve by a vulcanization tester on a rubber member in a crosslinking density measurement sheet and a time $t_{90}$ (measurement sheet) until reaching 90 % of a maximum torque at the time of measuring a vulcanization curve by a vulcanization tester on a rubber member in a crosslinking density measurement sheet satisfy the following equations (1) and (2):

$$0.8 \leq t_{10} \text{ (encapsulant)}/t_{10} \text{ (measurement sheet)} \leq 1.2 \quad (1)$$

$$0.8 \leq t_{90} \text{ (encapsulant)}/t_{90} \text{ (measurement sheet)} \leq 1.2 \quad (2)$$

(12) The method for manufacturing a crosslinking density measurement sheet as set forth in (11), wherein the solar cell module manufacturing laminator is a laminating apparatus having an upper chamber and a lower chamber partitioned from each other by a diaphragm, in which a material to be processed is disposed on a hot plate provided in the lower chamber, and the material to be processed as heated by the hot plate is laminated by evacuating the lower chamber, introducing the air into the upper chamber, and compressing the material by the hot plate and the pressing member;

(13) The method for manufacturing a crosslinking density measurement sheet as set forth in (11) to (12), wherein at least one of a slit part, a concave part, and a through-hole part is formed in the rubber sheet member;

(14) The method for manufacturing a crosslinking density measurement sheet as set forth in (13), wherein the slit part is linear and has a width of from 0.1 mm to 5 mm, and the number of the groove is 1 to 10 per cm of the rubber sheet member;

(15) The method for manufacturing a crosslinking density measurement sheet as set forth in (13), wherein the concave part is a linear groove having a width of from 0.1 mm to 5 mm, and the number of the groove is 1 to 10 per cm of the rubber sheet member;

(16) The method for manufacturing a crosslinking density measurement sheet as set forth in (13), wherein the number of the concave part or the through-hole part is 1 to 10 per $cm^2$ of the rubber sheet member;

(17) The method for manufacturing a crosslinking density measurement sheet as set forth in (13), (15) and (16), wherein the concave part of the rubber sheet member is fabricated by embossing;

(18) The method for manufacturing a crosslinking density measurement sheet as set forth in (11) to (17), wherein the crosslinking density of the rubber sheet member is from $9.0 \times 10^{-3}$ to $9.0 \times 10^{-7}$ moles/cm$^3$;

(19) The method for manufacturing a crosslinking density measurement sheet as set forth in (11) to (18), wherein a main component of the rubber sheet member is an ethylene/$\alpha$-olefin copolymer rubber (EPM) and/or an ethylene/$\alpha$-olefin/non-conjugated diene copolymer rubber (EPDM); and

(20) The method for manufacturing a crosslinking density measurement sheet as set forth in (19), wherein a carbon number of the $\alpha$-olefin is from 2 to 8.

The vulcanization test as referred to herein means one for measuring a vulcanization curve in conformity with JIS K6300. The measurement was carried out using, as a vulcanization tester, MDR2000, manufactured by Alpha Technology, at 150 °C. In addition, the crosslinking density can be measured by a solvent swelling method (Flory-Rehner method) as described later.

EFFECTS OF THE INVENTION

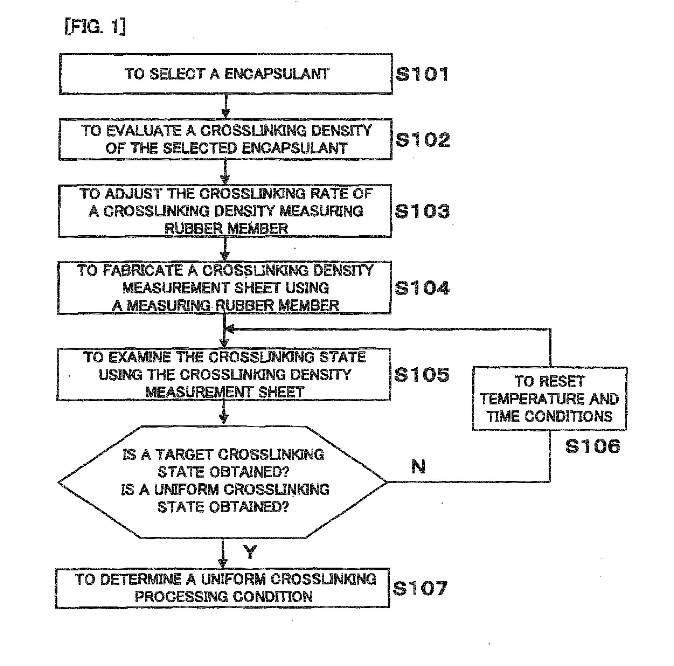

By using the crosslinking density measurement sheet in the present invention in accordance with a flow of Fig. 1, the crosslinking density within the laminating apparatus for manufacturing a solar cell can be easily estimated.

In evaluating the crosslinking density, after previously grasping a relation between an amount of a crosslinking agent and a crosslinking density and a relation between a kind of a crosslinking agent and a crosslinking aid in the sheet according to the present invention to prepare a calibration curve, a crosslinking density of a rubber sheet as material-designed so as to have substantially the same crosslinking density as the encapsulant is measured and adopted as a substitute for the crosslinking density of the encapsulant. Namely, by measuring the crosslinking density of the crosslinking density measurement sheet according to the present invention, the crosslinking density of the encapsulant of the solar cell module can be estimated.

According to this, not only a crosslinking density distribution of the encapsulant to be caused due to the temperature distribution within the laminating apparatus can be grasped within a short period of time, but it is also possible to estimate the crosslinking density on a lot of measuring points at one time measurement. According to this method, the crosslinking density of an EVA resin in which the crosslinking density cannot be usually evaluated by the swelling method can be indirectly estimated. In consequence, by using the crosslinking density measurement sheet, effects that the number of times of adjustment of setting temperature and setting time can be significantly reduced, and the manufacturing costs at the time of manufacturing a solar cell module can be suppressed are obtainable.

In addition, by constituting the crosslinking density measurement sheet in the way as described above, a crosslinking density measurement sheet can be designed such that at the time of separating a support and a rubber sheet layer and at the time of separating a glass layer and a rubber sheet layer, it can be integrally separated without causing breakage of the rubber sheet layer.

This crosslinking density measurement sheet can be suitably used for a laminating apparatus having an upper chamber and a lower chamber partitioned from each other by a diaphragm, in which a material to be processed is disposed on a hot plate provided in the lower chamber, and the material to be processed as heated by the hot plate is laminated by evacuating the lower chamber, introducing the air into the upper chamber, and compressing the material by the hot plate and the pressing member.

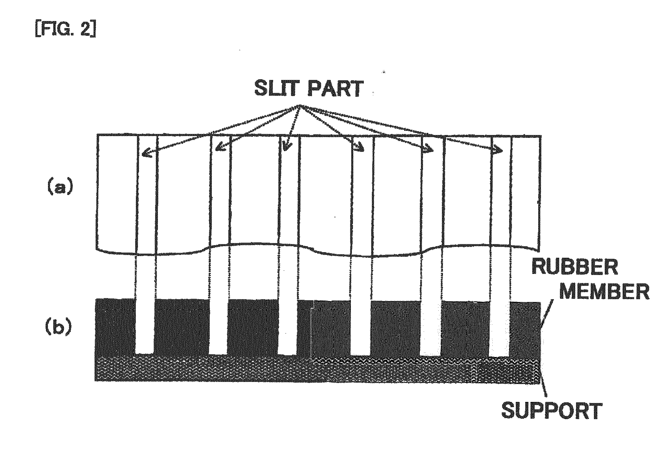

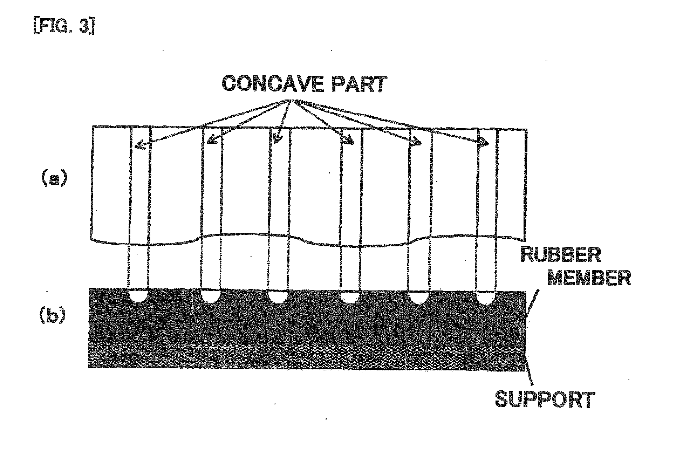

The crosslinking density measurement sheet that is the second invention is a crosslinking density measurement sheet comprising a rubber sheet member having a slit part, a concave part, or a hole part formed therein. In measuring the crosslinking density, since it is desirable to make the heating state the same as that at the time of fabricating the solar cell module, the measurement is frequently carried out in such a manner that a glass member the same as that used in the solar cell module is superimposed on the rubber member side of the crosslinking density measurement sheet. By adopting a constitution in which any one of a slit part, a concave part, or a hole part is formed in the rubber sheet member, in measuring the crosslinking density, when pressed, the rubber member is easily fluidized, so that the rubber member can be brought into intimate contact with the glass member leaving no space. For example, a slit part can be provided in the rubber sheet member as shown in Fig. 2, and a concave part can be provided in the rubber sheet member as shown in Fig. 3. Incidentally, even when a slit part is present in the rubber sheet member, the rubber member is fused and integrated by a laminating treatment, and therefore, the sheet can be separated together with the rubber sheet layer in an integrated state.

In addition, from the viewpoint of completely bringing the glass member and the rubber member into intimate contact with each other leaving no space, it is preferable that the concave part or the slit part is formed as a linear groove, and the groove has a width of from 0.1 mm to 5 mm and is present in a proportion of from 1 to 10 per cm of the rubber member; or that the concave part or the through-hole part is fabricated in a proportion of from 1 to 10 per cm$^2$ of the rubber sheet member. In addition, the concave part can be fabricated at low costs by means of embossing.

The crosslinking density measurement sheet that is the third invention is the foregoing crosslinking density measurement sheet in which the crosslinking density of the rubber sheet member is from $9.0 \times 10^{-3}$ to $9.0 \times 10^{-7}$

moles/cm$^3$. The crosslinking density of the rubber member can be adjusted by applying prescribed temperature and pressure. Even when the crosslinking density is too large or too small, characteristics as the rubber are not exhibited, and such is not preferable as a substitution index of the actual encapsulant.

In the crosslinking density measurement sheet that is the fourth invention, the rubber component is an ethylene/α-olefin copolymer rubber and/or an ethylene/α-olefin/non-conjugated diene copolymer rubber.

The crosslinking density measurement sheet that is the fifth invention is a crosslinking density measurement sheet in which a carbon number of the α-olefin is from 2 to 8. The fourth and fifth inventions are preferable from the standpoint that favorable moldability can be imparted to the crosslinking density measurement sheet.

The sixth invention is an invention related to a method for manufacturing a crosslinking density measurement sheet.

By manufacturing the crosslinking density measurement sheet such that $t_{10}$ (measurement sheet) and $t_{90}$ (measurement sheet) are adjusted to satisfy the following equations (1) and (2), the crosslinking density of the encapsulant and the crosslinking density of the crosslinking density measurement sheet can be treated alike, and grasping of the crosslinking density of the encapsulant becomes easier.

$$0.8 \leq t_{10} \text{ (encapsulant)}/t_{10} \text{ (measurement sheet)} \leq 1.2 \quad (1)$$

$$0.8 \leq t_{90} \text{ (encapsulant)}/t_{90} \text{ (measurement sheet)} \leq 1.2 \quad (2)$$

BRIEF DESCRIPTION OF THE DRAWINGS

Fig. 1 is an operation flowchart for adjusting a temperature distribution of a laminating apparatus for manufacturing a solar cell.
Fig. 2 is a diagrammatic view of a crosslinking density measurement sheet having a slit part in a rubber sheet member, in which Fig. 2 (a) is a plan view, and Fig. 2(b) is a cross-sectional view along a B-B line of Fig. 2(a).
Fig. 3 is a diagrammatic view of a crosslinking density measurement sheet having a linear concave part in a rubber sheet member, in which Fig. 3(a) is a plan view, and Fig. 3(b) is a cross-sectional view along a B-B line of Fig. 3(a).
Fig. 4 is a diagrammatic view of a crosslinking density measurement sheet having a hole part in a support, in which Fig. 4(a) is a plan view, and Fig. 4(b) is a cross-sectional view along a B-B line of Fig. 4(a).

BEST MODES FOR CARRYING OUT THE INVENTION

A use method of the crosslinking density measurement sheet according to the present invention is hereunder described on the basis of Fig. 1. First of all, selection of a encapsulant of a solar cell module is carried out (S101). Subsequently, a crosslinking rate of the selected encapsulant is evaluated using a vulcanization tester (S102).

Subsequently, the kind and amount of a crosslinking accelerator are adjusted such that a crosslinking rate of a rubber member in the crosslinking density measurement sheet according to the present invention is equivalent to the crosslinking rate of the selected encapsulant (S103). The crosslinking rate can be evaluated by a vulcanization tester (MDR) in conformity with JIS K-6300. In the case of measuring a time ($t_{10}$) until reaching 10 % of a maximum torque at the time of measuring a vulcanization curve of the encapsulant and the crosslinking density measuring rubber member by a vulcanization tester and a time ($t_{90}$) until reaching 90 % of a maximum torque at the time of measuring a vulcanization curve of the rubber by a vulcanization tester and satisfying the following equations (1) and (2), the crosslinking rate was regarded to be equivalent.

$$0.8 \leq t_{10} \text{ (encapsulant)}/t_{10} \text{ (measurement sheet)} \leq 1.2 \quad (1)$$

$$0.8 \leq t_{90} \text{ (encapsulant)}/t_{90} \text{ (measurement sheet)} \leq 1.2 \quad (2)$$

$t_{10}$ (encapsulant) : Time (minutes) until reaching 10 % of a maximum torque at the time of measuring a vulcanization curve by a vulcanization tester on the selected encapsulant for a solar cell module

$t_{90}$ (encapsulant) : Time (minutes) until reaching 90 % of a maximum torque at the time of measuring a vulcanization curve by a vulcanization tester on the selected encapsulant for a solar cell module

$t_{10}$ (measurement sheet): Time (minutes) until reaching 10 % of a maximum torque at the time of measuring a vulcanization curve by a vulcanization tester on the rubber sheet member in the crosslinking density measurement sheet

$t_{90}$ (measurement sheet): Time (minutes) until reaching 90 % of a maximum torque at the time of measuring a vulcanization curve by a vulcanization tester on the rubber sheet member in the crosslinking density measurement sheet

Thereafter, the adjusted rubber member and a substrate are stuck to each other, thereby fabricating a crosslinking density measurement sheet (S104). In addition, a crosslinking density obtained by adding 5 minutes to a value of $t_{90}$ (encapsulant) at the time of conducting the vulcanization test on an actually used encapsulant (an EVA resin, etc.) is regarded as a target crosslinking state, and a crosslinking time until the crosslinking density of the rubber member in a crosslinking test with a press becomes the target crosslinking state is regarded as an economically balanced molding condition. Incidentally, the time to be added to $t_{90}$ can be arbitrarily determined taking the life or power generation quantity of the solar cell module into consideration.

Subsequently, the laminating apparatus is set to the economically balanced molding condition, and the crosslinking density after crosslinking using the adjusted crosslinking density measurement sheet is measured, thereby evaluating a deviation from the target crosslinking state (S105). When the measured crosslinking density is not a value equivalent to the target crosslinking density, or the whole of the sheet is not uniformly crosslinked, re-setting of the temperature and time condition of the laminating apparatus is carried out (S106). By repeating the setting and evaluation until the measured crosslinking density becomes a value equivalent to the target crosslinking density, a condition under which the whole of the sheet can be uniformly crosslinked is determined (S107).

The crosslinking density measurement sheet according to the present invention is hereunder specifically described. The crosslinking density measurement sheet for a laminating apparatus of the present invention has a support and a rubber sheet layer. On the measurement sheet, a release sheet such as glass, TEFLON (a registered trademark), etc. may be properly superimposed and used, or other sheet may be laminated and used. However, it is preferable to measure the crosslinking density by using, as the support, a back sheet which is actually used for the production and putting thereon a glass member which is actually used for the production of a solar cell module.

<Support>

Any raw material can be used as the support so far as it is a sheet substrate having such heat resistance and proof strength that the shape can be kept at a crosslinking density measurement temperature. For example, there can be exemplified plastic sheets, papers, synthetic papers, fabrics, nonwoven fabrics, metal sheets, and the like. In addition, the foregoing substrate may be used upon being laminated, and a metal such as aluminum, etc. can also be used upon being vapor deposited on the substrate. Among the foregoing substrates, the substrate of the support is preferably a plastic sheet substrate from the viewpoints of moldability and processability. In addition, the substrate of the support is preferably a plastic sheet substrate made of a resin which is composed mainly of polyethylene terephthalate (PET) from the viewpoints of strength, heat resistance and costs. In addition, the use of a back sheet of a solar cell that is an actually produced support is preferable because the heating state of the rubber sheet member is similar to that of the solar cell module to be produced. Incidentally, the temperature range for measuring the crosslinking density is approximately from 120 °C to 180 °C.

<Rubber sheet member>

Examples of the component of the rubber include a natural rubber (NR) ; synthetic rubbers such as an isoprene rubber (BR), a styrene/butadiene rubber (SBR), a nitrile rubber (NBR), a butadiene rubber (IIR), a chloroprene rubber (CR), chlorosulfonated polyethylene (CSM), a butyl rubber (IIR), chlorinated polyethylene (CPE), a nitrile/isoprene rubber (NIR), an acrylic rubber (ACM), a urethane rubber (U), an epichlorohydrin rubber (CHR), a silicone rubber (Q), an ethylene/$\alpha$-olefin copolymer rubber (EPM), an ethylene/$\alpha$-olefin/non-conjugated diene copolymer rubber (EPDM), a fluorine rubber, etc.; and the like. These rubbers may be used solely or in admixture of two or more kinds thereof. In addition, the rubber sheet layer may be one composed mainly of a rubber component and may be kneaded or copolymerized with other resin compositions.

In addition, from the viewpoint of heat resistance, the rubber sheet member is preferably a crosslinked rubber such as an ethylene/$\alpha$-olefin copolymer rubber, an ethylene/$\alpha$-olefin/non-conjugated diene copolymer rubber, etc., or a kneaded material thereof. The ethylene/$\alpha$-olefin copolymer rubber (EPM) and the ethylene/$\alpha$-olefin/non-conjugated diene copolymer rubber (EPDM) are hereunder described in detail.

<$\alpha$-Olefin>

The $\alpha$-olefin which is used for the copolymer rubber is preferably one having a carbon number of from 2 to 8, and it may be used solely or in admixture of two or more kinds thereof. Examples of the $\alpha$-olefin having a carbon number of from 2 to 8 include propylene, 1-butene, 1-hexene, 1-octene, and the like. In particular, propylene having a carbon number of 3 can be preferably used.

<Non-conjugated diene>

As the non-conjugated diene which is used for the copolymer rubber, all of known non-conjugated dienes can be used. The non-conjugated diene may be used solely or in admixture of two or more kinds thereof. For examples, there can be exemplified chain non-conjugated diene compounds such as 1,4-hexadiene, 1,6-octadiene, 2-methyl-1,5-hexadiene, 6-methyl-1,5-heptadiene, 7-methyl-1,6-octadiene, etc.; and cyclic non-conjugated diene compounds such as vinylcyclohexene, cyclohexadiene, methyl tetrahydroindene, 5-vinyl-2-norbornene, 5-ethylidene-2-norbornene, 5-methylene-2-norbornene, 5-isopropylidene-2-norbornene, 6-chloromethyl-5-isopropenyl-2-norbornene, etc.
Of these, 5-ethylidene-2-norbornene (ENB) ispreferable as the non-conjugated diene.

<Crosslinking density>

The crosslinking density described in the present invention is one measured by the following method which is called a solvent swelling method (Flory-Rehner method).

<Solvent swelling method (Flory-Rehner method)>

A test piece of 20 mm $\times$ 20 mm $\times$ 2 mm was punched out from a sheet obtained by press processing a sample into a thickness of 2 $\pm$ 0.05 mm and dipped in and swollen with 100 mL of toluene at 37 °C for 72 hours in conformity with JIS K6258. The crosslinking density was then determined according to the following Flory-Rehner equation (equation (3)) utilizing equilibrium swelling.

$$\nu = \{V_R + ln\,(1 - V_R) + \mu V_R{}^2\}/\{-V_0(V_R{}^{1/2} - V_R/2)\} \quad (3)$$

$\nu$: Crosslinking density (mole/cm$^3$)
$V_R$: Volume fraction of pure rubber in the swollen rubber sheet member
$\mu$: Interaction constant between rubber and toluene as the solvent (0.49)
$V_0$: Molar volume of toluene (108.15 cm$^3$)

Incidentally, $V_R$ was determined according to the following equation (2).

$$V_R = V_r/(V_r + V_s) \quad (2)$$

$V_r$: Volume of pure rubber in the test piece (cm$^3$)
$V_s$: Volume of solvent absorbed on the test piece (cm$^3$)

<Crosslinking agent>

In order to adjust the crosslinking density, known crosslinking agents inclusive of sulfur or sulfur based vulcanizing agents and organic peroxides (e.g., diacyl peroxide based compounds, alkyl peroxy ester based compounds, peroxy dicarbonate based compounds, peroxy carbonate based compounds, peroxy ketal based compounds, dialkyl peroxide based compounds, hydroperoxide based compounds, ketone peroxide based compounds) can be used. In particular, according to the crosslinking with sulfur, sulfur is not vaporized, and it is easy to predict the crosslinking density from the addition amount. Therefore, sulfur can be suitably utilized as the additive. Specifically, examples of the sulfur include powdered sulfur, precipitated sulfur, colloidal sulfur, surface treated sulfur, insoluble sulfur, and the like. Examples of the sulfur based vulcanizing agent include tetramethylthiuram monosulfide, zinc dimethyl dithiocarbamate, zinc di-n-butyl dithiocarbamate, and the like. Examples of the organic peroxide include dicumyl peroxide, di-t-butyl peroxide, t-butyl cumyl peroxide, 2,5-dimethyl-2,5-di(t-butylperoxy)hexane, 2,5-dimethyl-2,5-di(t-butylperoxy)hexine, 3,1,1-bis-t-butylperoxy-3,3,5-trimethylcyclohexane, and the like, and those having a 10-hour half-life temperature of 80 °C or higher are preferable.

<Vulcanization accelerator>

In the case of using a sulfur based compound as the vulcanizing agent, it is preferable to use a vulcanization accelerator in combination. For example, there can be exemplified thiazole based vulcanization accelerators such as N-cyclohexyl-2-benzothiazole sulfenamide, N-oxydiethylene-2-benzothiazole sulfenamide, N,N'-diisopropyl-2-benzothiazole sulfenamide, 2-mercaptobenzothiazole, 2-(2,4-dinitrophenyl)mercaptobenzothiazole, 2-(2,6-diethyl-4-morpholinothio)benzothiazole, dibenzothiazyl disulfide, etc.; guanidine based vulcanization accelerators such as diphenyl guanidine, triphenyl guanidine, di-o-tolyl guanidine, etc.; aldehyde amine based vulcanization accelerators such as an acetaldehyde-aniline condensate, a butyl aldehyde-aniline condensate, etc.; imidazoline based vulcanization accelerators such as 2-mercaptoimiazoline, etc.; thiourea based vulcanization accelerators such as diethylthiourea, dibutylthiourea, etc.; thiuram based vulcanization accelerators such as tetramethylthiuram monosulfide, tetramethylthiuram disulfide, dipentamethylenethiuram tetrasulfide, etc.; dithioic acid salt based vulcanization accelerators such as zinc dimethyldithiocarbamate, zinc diethyldithiocarbamate, tellurium diethyldithiocarbamate, etc.; xanthate based vulcanization accelerators such as zinc dibutyl xanthogenate, etc.; and besides, zinc white; and the like.

<Other additives>

For the crosslinking density measurement sheet of the present invention, other additives can also be used as the need arises. As specific examples of the additive, there can be exemplified a foaming agent, a foaming aid, a reinforcing agent, an inorganic filler, a softening agent, a stabilizer, a processing aid, a plasticizer, a catalyst for crosslinking of a coloring agent, a pigment, an ultraviolet absorber, a flame retardant, a reaction inhibitor, and the like. In such an additive, its kind and content are properly selected.

<Production method of synthetic rubber>

The synthetic rubber is produced by a conventionally known method, and the production is not particularly limited with respect to a polymerization catalyst and a polymerization condition. As the polymerization catalyst, a variety of conventionally known catalysts, for example, a Ziegler-Natta catalyst, a metallocene catalyst, an imine catalyst, a phenoxyimine catalyst, etc. can be used. As for the polymerization method, a conventionally known polymerization method, for example, solution polymerization, slurry polymerization, block polymerization, etc. can be adopted. Specifically, for example, the synthetic rubber can be obtained by continuously feeding the respective monomers into a reactor, allowing a copolymerization reaction to proceed in the presence of a catalyst at a prescribed temperature, and then separating and drying the obtained copolymer rubber.

<Molding of rubber sheet member>

Molding of the rubber sheet member can be carried out by a variety of conventionally known methods such as calendar molding, injection molding, extrusion molding, compression molding, vacuum molding, etc. In the fabrication of the crosslinking density measurement sheet, the support layer and the rubber sheet layer may be stuck later, or the rubber sheet layer may be molded directly on the support layer.

<Formation of slit part, concave part, or through-hole part in rubber member>

The method for forming a slit part, a concave part, or a through-hole part in the rubber sheet member is not particularly limited, and conventionally known methods can be adopted. For example, as a method for fabricating a concave part, an embossing method can be adopted; and as a method for fabricating a hole part, there is exemplified a method in which a pair of rolls is prepared, a lot of pins are provided on the surface of one or both of the rolls, and a rubber sheet member is fed into the pair of rolls, thereby allowing the pins on the roll surface to prick the rubber sheet member.

<Formation of through-hole part on support>

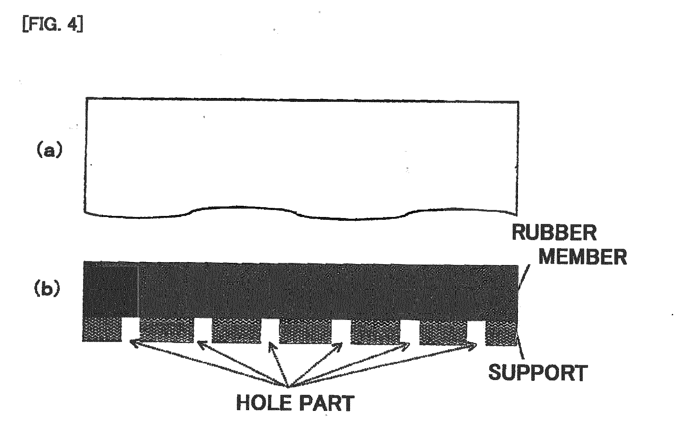

For the purpose of removing air bubbles between the support and the rubber member, for example, a through-hole part can also be provided on the support as shown in Fig. 4. As a method for fabricating a hole part, similar to the foregoing rubber sheet member, there is exemplified a method in which a pair of rolls is prepared, a lot of pins are provided on the surface of one or both of the rolls, and a rubber sheet member is fed into the pair of rolls, thereby allowing the pins on the roll surface to prick the rubber sheet member.

The present invention is hereunder described in more detail with reference to Examples, but it should not be construed that the present invention is limited thereto.

[Example 1]

<Sheet composition and molding method>

100 parts by mass of an EPDM based rubber (EPT4010, manufactured by Mitsui Chemicals, Inc.) was kneaded with 50 parts by mass of carbon black, 50 parts by mass of an oil, 1 part by mass of stearic acid, and 5 parts by mass of zinc white No. 1 for 15 minutes by a 50-L kneader, thereby obtaining a compound. After the temperature reached not higher than 90 °C, a rubber compound having 0.5 parts by mass of sulfur, 1 part by mass of a thiuram based vulcanization accelerator (NOCCELER TT, manufactured by Ouchi Shinko Chemical Industrial Co., Ltd.), and 1.5 parts by mass of a thiuram based vulcanization accelerator (NOCCELER TRA, manufactured by Ouchi Shinko Chemical Industrial Co., Ltd.) blended therein was fabricated, from which was then fabricated a 1 mm-thick sheet having a size of 60 cm $\times$ 70 cm, and the sheet was placed on a glass and crosslinked by a laminator under a condition at 150 °C for 15 minutes. In addition, a slit having a width of 1 mm was fabricated in a proportion of 4 lines per cm.

<Vulcanization test>

The crosslinking rate can be evaluated in conformity with JIS K6300 by measuring a time $t_{10}$ until reaching 10 % of a maximum torque at the time of measuring a vulcanization curve by a vulcanization tester and a time $t_{90}$ until reaching 90 % of a maximum torque at the time of measuring a vulcanization curve by a vulcanization tester. Incidentally, the values of $t_{10}$ and $t_{90}$ are each an index of the crosslinking rate. What the values of $t_{10}$ and $t_{90}$ are small means that the crosslinking proceeds faster, and what the values of $t_{10}$ and $t_{90}$ are large means that the crosslinking proceeds more slowly. The measurement was carried out at 150 °C using, as a vulcanization tester, MDR2000, manufactured by Alpha Technology in conformity with JIS K6300.

<Evaluation of adhesion>

In addition, after the crosslinking reaction by a laminator, the adhesion of the encapsulant to the glass was visually evaluated. The evaluation was made on the basis of two grades of from 1 to 2 according to the following criteria.

1: When observed from the glass surface, a lot of non adhesion parts such as air bubbles, etc. are present.
2: When observed from the glass surface, a non adhesion part such as air bubbles, etc. is not present at all.

[Example 2]

A crosslinking density measurement sheet was fabricated in the same manner as that in Example 1, except for changing the crosslinking time to 30 minutes.

[Example 3]

A crosslinking density measurement sheet was fabricated in the same manner as that in Example 1, except for changing the crosslinking time to 45 minutes.

[Example 4]

The addition amount of sulfur was changed to 0.3 parts by mass; the addition amount of the thiuram based vulcanization accelerator (NOCCELER TT, manufactured by Ouchi Shinko Chemical Industrial Co. , Ltd. ) was changed to 0.5 parts by mass; the addition amount of the thiuram based vulcanization accelerator (NOCCELER TRA, manufactured by Ouchi Shinko Chemical Industrial Co., Ltd. ) was changed to 1.0 part by mass; the crosslinking temperature was changed to 160 °C; and the crosslinking time was changed to 30 minutes. In addition, a linear groove was not fabricated. A crosslinking density measurement sheet was fabricated in the same manner as that in Example 1, except for the foregoing.

[Example 5]

The addition amount of sulfur was changed to 0.3 parts by mass; the addition amount of the thiuram based vulcanization accelerator (NOCCELER TT, manufactured by Ouchi Shinko Chemical Industrial Co. , Ltd. ) was changed to 0.5 parts by mass; the addition amount of the thiuram based vulcanization accelerator (NOCCELER TRA, manufactured by Ouchi Shinko Chemical Industrial Co., Ltd. ) was changed to 1.0 part by mass; the crosslinking temperature was changed to 160 °C; and the crosslinking time was changed to 45 minutes. A crosslinking density measurement sheet was fabricated in the same manner as that in Example 1, except for the foregoing.

In addition, as Referential Example, values of $t_{10}$ and $t_{90}$ of an EVA resin (SOLAR EVA SC4, manufactured by Mitsui Chemical Fablo Inc.) which is actually used as the encapsulant by the vulcanization test were measured and regarded as $t_{10}$ (encapsulant) and $t_{90}$ (encapsulant).

The crosslinking conditions and vulcanization test results of the Examples and Referential Example are shown in Tables 1 and 2. In addition, as referential values, the values of $t_{10}$ and $t_{90}$ of the EVA encapsulant which is used for a encapsulant of a solar cell module are shown in Table 1.

As in Examples 1 to 3, the crosslinking density measurement sheets were fabricated, and a laminator for manufacturing a solar cell module was then set. As a result, a time required until the laminating processing became possible after setting was 48 hours. In addition, the crosslinking density measurement sheets described in Examples 4 to 5 were fabricated, and a laminator for manufacturing a solar cell module was then set. As a result, a time required until the laminating processing became possible after setting was 48 hours. On the other hand, a laminator for manufacturing a solar cell module was set without using a crosslinking density measurement sheet. As a result, a time required until the laminating processing became possible after setting was 334 hours.

According to this, in view of the fact that the crosslinking density of the solar cell to be produced can be precisely estimated by setting the condition of the laminator for manufacturing a solar cell using the crosslinking density measurement sheet, it becomes possible to significantly shorten a time for setting the condition of a solar cell laminator.

Table 1

|  |  |  | Referential Example | Example 1 | Example 2 | Example 3 |
|---|---|---|---|---|---|---|
| Fabrication condition |  |  |  |  |  |  |
|  | Crosslinking condition | Temperature (°C) | - | 150 | 150 | 150 |
|  |  | Time (minute) | - | 15 | 30 | 45 |
|  | Presence or absence of concave or slit | Width (mm) | - | 1 | 1 | 1 |
|  |  | Density (per cm) | - | 4 | 4 | 4 |
| Measurement results |  |  |  |  |  |  |
|  | Crosslinking density (mole/cm$^3$) |  | - | $0.8 \times 10^{-4}$ | $1.3 \times 10^{-4}$ | $1.3 \times 10^{-4}$ |
|  | Vulcanization test | $t_{10}$ (minute) | 7 | 8 | 8 | 8 |
|  |  | $t_{90}$ (minute) | 25 | 26 | 26 | 26 |
|  | $t_{10}$ (encapsulant)/$t_{10}$ (measurement sheet) |  | - | 1.14 | 1.14 | 1.14 |
|  | $t_{90}$ (encapsulant)/$t_{90}$ (measurement sheet) |  | - | 1.04 | 1.04 | 1.04 |
|  | Adhesion |  | - | 2 | 2 | 2 |

Table 2

|  |  |  | Example 4 | Example 5 |
|---|---|---|---|---|
| Fabrication condition |  |  |  |  |
|  | Crosslinking condition | Temperature (°C) | 160 | 160 |
|  |  | Time (minute) | 30 | 45 |
|  | Presence or absence of concave or slit | Width (mm) | No | 1 |
|  |  | Density (per cm) | No | 4 |

(continued)

| Measurement results | | | | |
|---|---|---|---|---|
| | Crosslinking density (mole/cm$^3$) | | $1.0 \times 10^{-4}$ | $1.2 \times 10^{-4}$ |
| | Vulcanization test | $t_{10}$ (minute) | 14 | 14 |
| | | $t_{90}$ (minute) | 45 | 45 |
| | $t_{10}$ (encapsulant)/$t_{10}$ (measurement sheet) | | 2 | 2 |
| | $t_{90}$ (encapsulant)/$t_{90}$ (measurement sheet) | | 1.8 | 1.8 |
| | Adhesion | | 1 | 2 |

## Claims

1. A crosslinking density measurement sheet comprising a composite sheet provided with a support and a rubber sheet member integrated with the support, wherein
a crosslinking density of a encapsulant within a solar cell module can be calculated from a change of crosslinking density of the rubber sheet member before and after a laminating treatment by a solar cell module manufacturing laminator.

2. The crosslinking density measurement sheet according to claim 1, wherein the solar cell module manufacturing laminator is a laminating apparatus having an upper chamber and a lower chamber partitioned from each other by a diaphragm, in which a material to be processed is disposed on a hot plate provided in the lower chamber, and the material to be processed as heated by the hot plate is laminated by evacuating the lower chamber, introducing the air into the upper chamber, and compressing the material by the hot plate and the pressing member.

3. The crosslinking density measurement sheet according to claims 1 to 2, wherein at least one of a slit part, a concave part, and a through-hole part is formed in the rubber sheet member.

4. The crosslinking density measurement sheet according to claim 3, wherein the slit part is a linear groove having a width of from 0.1 mm to 5 mm, and the number of the groove is 1 to 10 per cm of the rubber sheet member.

5. The crosslinking density measurement sheet according to claim 3, wherein the concave part is a linear groove having a width of from 0.1 mm to 5 mm, and the number of the groove is 1 to 10 per cm of the rubber sheet member.

6. The crosslinking density measurement sheet according to claim 3, wherein the number of the concave part or the through-hole part is 1 to 10 per cm$^2$ of the rubber sheet member.

7. The crosslinking density measurement sheet according to claims 3, 5 and 6, wherein the concave part is fabricated by embossing.

8. The crosslinking density measurement sheet according to claims 1 to 7, wherein the crosslinking density of the rubber sheet member is from $9.0 \times 10$ to $9.0 \times 10^{-7}$ moles/cm$^3$.

9. The crosslinking density measurement sheet according to claims 1 to 8, wherein a main component of the rubber sheet member is an ethylene/$\alpha$-olefin copolymer rubber (EPM) and/or an ethylene/$\alpha$-olefin/non-conjugated diene copolymer rubber (EPDM).

10. The crosslinking density measurement sheet according to claim 9, wherein a carbon number of the $\alpha$-olefin is from 2 to 8.

11. A method for manufacturing a crosslinking density measurement sheet including a composite sheet provided with a support and a rubber sheet member integrated with the support, wherein a crosslinking density of a encapsulant within a solar cell module can be calculated from a change of crosslinking density of the rubber sheet member before and after a laminating treatment by a solar cell module manufacturing laminator, the method comprising a step of measuring a time $t_{10}$ (encapsulant) until reaching 10 % of a maximum torque at the time of measuring a vulcanization curve by a vulcanization test on a encapsulant for a solar cell module,
a step of measuring a time $t_{90}$ (encapsulant) until reaching 90 % of a maximum torque at the time of measuring a vulcanization curve by a vulcanization test on a encapsulant for a solar cell module, and
a step of adjusting a crosslinking rate by adding an additive to a rubber member such that a time $t_{10}$ (measurement sheet) until reaching 10 % of a maximum torque at the time of measuring a vulcanization curve by a vulcanization tester on a rubber member in a crosslinking density measurement sheet and a time $t_{90}$ (measurement sheet) until reaching 90 % of a maximum torque at the time of measuring a vulcanization curve by a vulcanization tester on a rubber member in a crosslinking density measurement sheet satisfy the following equations (1) and (2):

$$0.8 \leq t_{10} \text{ (encapsulant)}/t_{10} \text{ (measurement sheet)} \leq 1.2 \quad (1)$$

$$0.8 \leq t_{90} \text{ (encapsulant)}/t_{90} \text{ (measurement sheet)} \leq 1.2 \quad (2)$$

12. The method for manufacturing a crosslinking density measurement sheet according to claim 11, wherein the solar cell module manufacturing laminator is a laminating apparatus having an upper chamber and a lower chamber partitioned from each other by a diaphragm, in which a material to be processed is disposed on a hot plate provided in the lower chamber, and the material to be processed as heated by the hot plate is laminated by evacuating the lower chamber, introducing the air into the upper chamber, and compressing the material by the hot plate and the pressing member.

13. The method for manufacturing a crosslinking density measurement sheet according to claims 11 to 12, wherein at least one of a slit part, a concave part, and a through-hole part is formed in the rubber sheet member.

14. The method for manufacturing a crosslinking density measurement sheet according to claim 13, wherein the slit part is a linear groove having a width of from 0.1 mm to 5 mm, and the number of the groove is 1 to 10 per cm of the rubber sheet member.

15. The method for manufacturing a crosslinking density measurement sheet according to claim 13, wherein the concave part is a linear groove having a width of from 0.1 mm to 5 mm, and the number of the groove is 1 to 10 per cm of the rubber sheet member.

16. The method for manufacturing a crosslinking density measurement sheet according to claim 13, wherein the number of the concave part or the through-hole part is 1 to 10 per cm$^2$ of the rubber sheet member.

17. The method for manufacturing a crosslinking density measurement sheet according to claims 13, 15 and 16, wherein the concave part is fabricated by embossing.

18. The method for manufacturing a crosslinking density measurement sheet according to claims 11 to 17, wherein the crosslinking density of the rubber sheet member is from $9.0 \times 10^{-3}$ to $9.0 \times 10^{-7}$ moles/cm$^3$.

19. The method for manufacturing a crosslinking density measurement sheet according to claims 11 to 18, wherein a main component of the rubber sheet member is an ethylene/$\alpha$-olefin copolymer rubber (EPM) and/or an ethylene/$\alpha$-olefin/non-conjugated diene copolymer rubber (EPDM).

20. The method for manufacturing a crosslinking density measurement sheet according to claim 19, wherein a carbon number of the $\alpha$-olefin is from 2 to 8.

[FIG. 1]

```
┌─────────────────────────────────────┐
│     TO SELECT A ENCAPSULANT         │ S101
└─────────────────────────────────────┘
                │
                ▼
┌─────────────────────────────────────┐
│   TO EVALUATE A CROSSLINKING DENSITY │ S102
│     OF THE SELECTED ENCAPSULANT      │
└─────────────────────────────────────┘
                │
                ▼
┌─────────────────────────────────────┐
│  TO ADJUST THE CROSSLINKING RATE OF  │
│   A CROSSLINKING DENSITY MEASURING   │ S103
│           RUBBER MEMBER              │
└─────────────────────────────────────┘
                │
                ▼
┌─────────────────────────────────────┐
│  TO FABRICATE A CROSSLINKING DENSITY │
│       MEASUREMENT SHEET USING        │ S104
│     A MEASURING RUBBER MEMBER        │
└─────────────────────────────────────┘
                │
                ▼
┌─────────────────────────────────────┐        ┌──────────────────┐
│  TO EXAMINE THE CROSSLINKING STATE   │        │    TO RESET       │
│   USING THE CROSSLINKING DENSITY     │ S105   │ TEMPERATURE AND   │
│        MEASUREMENT SHEET             │        │ TIME CONDITIONS   │
└─────────────────────────────────────┘        └──────────────────┘
                │                                        S106
                ▼
        ╱───────────────────╲
       ╱ IS A TARGET CROSSLINKING╲
      ╱   STATE OBTAINED?          ╲  N
      ╲   IS A UNIFORM CROSSLINKING╱────►
       ╲    STATE OBTAINED?       ╱
        ╲───────────────────╱
                │ Y
                ▼
┌─────────────────────────────────────┐
│ TO DETERMINE A UNIFORM CROSSLINKING  │ S107
│        PROCESSING CONDITION          │
└─────────────────────────────────────┘
```

[FIG. 2]

SLIT PART

(a)

(b)

RUBBER
MEMBER

SUPPORT

[FIG. 3]

CONCAVE PART

(a)

(b)

RUBBER MEMBER

SUPPORT

[FIG. 4]

(a)

(b)

RUBBER
MEMBER

SUPPORT

HOLE PART

## INTERNATIONAL SEARCH REPORT

International application No.

PCT/JP2011/054836

### A. CLASSIFICATION OF SUBJECT MATTER
*H01L31/048*(2006.01)i

According to International Patent Classification (IPC) or to both national classification and IPC

### B. FIELDS SEARCHED

Minimum documentation searched (classification system followed by classification symbols)
H01L31/04-31/078

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2008-117926 A (Mitsui Chemicals, Inc.), 22 May 2008 (22.05.2008), entire text; all drawings (Family: none) | 1-20 |
| A | JP 2007-240359 A (Mitsui Chemical Analysis & Consulting Service Inc.), 20 September 2007 (20.09.2007), entire text; all drawings (Family: none) | 1-20 |
| A | JP 4-204364 A (Mazda Motor Corp.), 24 July 1992 (24.07.1992), entire text; all drawings (Family: none) | 1-20 |

☒ Further documents are listed in the continuation of Box C. ☐ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | |
| "O" | document referring to an oral disclosure, use, exhibition or other means | "Y" document of particular relevance; the claimed invention cannot be considered to involve an inventive step when the document is combined with one or more other such documents, such combination being obvious to a person skilled in the art |
| "P" | document published prior to the international filing date but later than the priority date claimed | "&" document member of the same patent family |

| | |
|---|---|
| Date of the actual completion of the international search | Date of mailing of the international search report |
| 28 April, 2011 (28.04.11) | 17 May, 2011 (17.05.11) |
| Name and mailing address of the ISA/ | Authorized officer |
| Japanese Patent Office | |
| Facsimile No. | Telephone No. |

Form PCT/ISA/210 (second sheet) (July 2009)

**INTERNATIONAL SEARCH REPORT**

| | International application No. |
|---|---|
| | PCT/JP2011/054836 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2003-344322 A  (Inoac Corp.),<br>03 December 2003 (03.12.2003),<br>entire text; all drawings<br>(Family: none) | 1-20 |
| A | JP 3-206952 A  (Mazda Motor Corp.),<br>10 September 1991 (10.09.1991),<br>entire text; all drawings<br>(Family: none) | 1-20 |
| A | JP 2007-238783 A  (Mitsui Chemicals, Inc.),<br>20 September 2007 (20.09.2007),<br>entire text; all drawings<br>(Family: none) | 1-20 |
| A | JP 2006-322923 A  (Canon Inc.),<br>30 November 2006 (30.11.2006),<br>entire text; all drawings<br>& US 2006/0231965 A1 | 1-20 |

Form PCT/ISA/210 (continuation of second sheet) (July 2009)